# EUROPEAN PATENT APPLICATION

(11) **EP 4 765 185 A1**
(43) Date of publication of application: **24.06.2026**
(21) Application number: 24874014.4
(22) Date of filing: 19.07.2024
(51) Int. Cl.: H01J 9/20

(54) **FILM LAYER STRUCTURE AND PREPARATION METHOD**

(30) Priority: 07.10.2023 CN 202311283852
(71) Applicant: Jiangsu Leuven Instruments Co., Ltd., Xuzhou, Jiangsu 221300 (CN)
(72) Inventor: LI, Xuedong, Xuzhou, Jiangsu 221300 (CN); HE, Xiaoming, Xuzhou, Jiangsu 221300 (CN); ZOU, Bo, Xuzhou, Jiangsu 221300 (CN); WANG, Cong, Xuzhou, Jiangsu 221300 (CN); HU, Jie, Xuzhou, Jiangsu 221300 (CN); YANG, Zhen, Xuzhou, Jiangsu 221300 (CN); ZHENG, Tiancheng, Xuzhou, Jiangsu 221300 (CN); HU, Dongdong, Xuzhou, Jiangsu 221300 (CN); XU, Kaidong, Xuzhou, Jiangsu 221300 (CN)
(74) Representative: Eisenführ Speiser
(86) International application number: PCT/CN2024/106369
(87) International publication number: WO 2025/073195

(57) **Abstract**

A film layer structure and a preparation method. The preparation method comprises: forming a first ceramic coating (11) by means of an atmospheric plasma spray-coating process or an evaporation process; forming a second ceramic coating (12) on the side of the first ceramic coating (11) away from a substrate by means of a suspension plasma spray-coating process; and forming a third ceramic coating (13) on the side of the second ceramic coating (12) away from the substrate by means of a chemical vapor deposition process or a physical vapor deposition process. The first ceramic coating (11) prepared by means of the atmospheric plasma spray-coating process or the evaporation process has a good interface bonding force. The second ceramic coating (12) prepared by means of the suspension plasma spray-coating process can reduce the roughness and porosity of the film layer structure. The third ceramic coating (13) prepared by means of the chemical vapor deposition process or the physical vapor deposition process reduces defects such as cracks in the film layer structure, thereby obtaining a smooth and compact film layer structure surface without crack defects, which surface can enhance the cleaning function of plasma cleaning of process by-products adhered on a chamber lining of a plasma device when said surface is applied to the chamber lining.

## Description

This application claims priority to Chinese Patent Application No. 202311283852.1, titled "FILM LAYER STRUCTURE AND PREPARATION METHOD", filed on October 07, 2023 with the China National Intellectual Property Administration, which is incorporated herein by reference in its entirety.

### FIELD

The present application relates to the field of semiconductor technology, and in particular to a film layer structure and a preparation method.

### BACKGROUND

The conventional inductively coupled plasma etching process (ICP etching, Inductive coupled plasma etching) is conducted by alternating between two workflows: wafer etching followed by either chamber in-situ plasma cleaning (Chamber in-situ cleaning) or no-wafer plasma cleaning (No wafer clean, NWC).

The purpose of plasma cleaning is to remove defects or process byproducts deposited within the chamber after a previous plasma etching of a wafer. As the etching process proceeds for an extended period, the defects or deposited process byproducts accumulate continuously, making it difficult for the next wafer to be processed in a stable chamber environment. It is therefore essential to perform plasma cleaning after each wafer etching to remove deposits in the chamber.

However, the efficiency of plasma cleaning also depends on the surface condition of the film layer structure of the workpiece inside the chamber. Generally, the removal of the process byproducts via plasma cleaning becomes more effective on smoother and flatter film layer structure of the workpiece.

However, the surface of chamber liners currently in use is often insufficiently smooth and flat, with relatively high surface defects and roughness, which seriously impacts the stability and yield of the plasma etching process.

### SUMMARY

In light of the above, the summary of the present application is provided to introduce briefly the concepts, and these concepts would be described in detail in the following detailed description section. The summary of the present application is not intended to identify key or essential features of the claimed technical solutions, nor is it intended to limit the scope of the claimed technical solutions.

The present application aims to provide a film layer structure and a manufacturing method. The surface of the film layer structure is smooth, dense and free of defects such as cracks, which can improve the stability and yield of plasma etching process.

To achieve the above objective, the present application provides the following technical solutions:
In a first aspect, a method for manufacturing a film layer structure is provided according to an embodiment of the present application, and the film layer structure is applied to a plasma apparatus. The method comprises:
providing a substrate;
forming a multilayer ceramic coating on a side of the substrate; where a roughness and a porosity of the multilayer ceramic coating gradually decrease from a side close to the substrate to a side away from the substrate.

In an embodiment, the multilayer ceramic coating comprises a first ceramic coating, a second ceramic coating, and a third ceramic coating, and forming the multilayer ceramic coating on a side of the substrate comprises:
forming the first ceramic coating on the substrate via an atmospheric plasma spraying process or an evaporation process;
forming the second ceramic coating on a side of the first ceramic coating away from the substrate via a suspension plasma spraying process;
forming the third ceramic coating on a side of the second ceramic coating away from the substrate via a chemical vapor deposition process, a physical vapor deposition process, a plasma-enhanced chemical vapor deposition process, or a plasma-enhanced physical vapor deposition process.

In an embodiment, a material of the substrate includes aluminum or aluminum alloy.

In an embodiment, a material of the first ceramic coating includes aluminium oxide, yttrium oxide, yttrium fluoride, yttrium oxyfluoride or yttrium aluminum garnet.

In an embodiment, a material of the second ceramic coating includes aluminium oxide, yttrium oxide, yttrium fluoride, yttrium oxyfluoride or yttrium aluminum garnet.

In an embodiment, a material of the third ceramic coating includes aluminium oxide, yttrium oxide, yttrium fluoride, yttrium oxyfluoride or yttrium aluminum garnet.

In an embodiment, the second ceramic coating comprises a first ceramic sub-layer and a second ceramic sub-layer.

In an embodiment, a thickness of the first ceramic coating is greater than or equal to 50 µm and less than or equal to 500 µm.

In an embodiment, a thickness of the second ceramic coating is greater than or equal to 50 µm and less than or equal to 500 µm.

In an embodiment, a thickness of the third ceramic coating is greater than or equal to 2 µm and less than or equal to 200 µm.

In an embodiment, the porosity of the first ceramic coating is greater than or equal to 3% and less than or equal to 8%.

In an embodiment, the porosity of the second ceramic coating is less than or equal to 3%.

In an embodiment, the porosity of the third ceramic coating is less than or equal to 0.1%.

In an embodiment, the roughness of the first ceramic coating is greater than or equal to 3 µm and less than or equal to 8 µm.

In an embodiment, the roughness of the second ceramic coating is greater than or equal to 1.0 µm and less than or equal to 4 µm.

In an embodiment, the roughness of the third ceramic coating is less than or equal to 1 µm.

In an embodiment, the aluminum alloy includes copper element, silicon element, iron element, manganese element, magnesium element, zinc element, chromium element and/or titanium element.

In an embodiment, the aluminum alloy is 6061 aluminum plate alloy.

In a second aspect, a film layer structure is provided according to an embodiment of the present application. The film layer structure is applied to the plasma apparatus comprising a plasma etching device and a plasma coating device, and is manufactured by the aforementioned method. The film layer structure comprises:
a substrate;
a multilayer ceramic coating, located on a side of the substrate;
where a roughness and a porosity of the multilayer ceramic coating gradually decrease from a side close to the substrate to a side away from the substrate.

In an embodiment, the multilayer ceramic coating comprises a first ceramic coating, a second ceramic coating, and a third ceramic coating, and materials of the first ceramic coating, the second ceramic coating, and the third ceramic coating include aluminium oxide, yttrium oxide, yttrium fluoride, yttrium oxyfluoride or yttrium aluminum garnet.

Compared to the conventional technology, embodiments of the present application have the following advantages:
The embodiments of the present application provide a film layer structure and manufacturing method. The method comprises: providing a substrate; forming the first ceramic coating on the substrate via an atmospheric plasma spraying process or an evaporation process; forming the second ceramic coating on a side of the first ceramic coating away from the substrate via a suspension plasma spraying process; and forming the third ceramic coating on a side of the second ceramic coating away from the substrate via a chemical vapor deposition process or a physical vapor deposition process. The first ceramic coating, prepared in the present application via the atmospheric plasma spraying process or the evaporation process, exhibits excellent interfacial bonding strength, thereby facilitating bonding with the substrate. The second ceramic coating prepared by the suspension plasma spraying process can reduce the roughness and porosity of the film layer structure. The third ceramic coating prepared by the chemical vapor deposition process or the physical vapor deposition process can further reduce defects such as cracks in the film layer structure. Thus, a smooth, dense, crack-free film layer structure surface is obtained. Applying the smooth, dense, crack-free film structure to the chamber liner of the plasma apparatus facilitates enhancing the plasma cleaning function of the plasma cleaning on the process byproducts attached to the chamber liner during the plasma etching process, thereby improving the stability and yield of the plasma etching process.

### BRIEF DESCRIPTION OF THE DRAWINGS

Hereinafter drawings to be applied in embodiments of the present application are briefly described, in order to clarify illustration of technical solutions according to embodiments of the present application. Apparently, the drawings in the following descriptions are only some embodiments of the present application, and other drawings may be obtained by those skilled in the art based on the provided drawings without exerting creative efforts.

The above and other features, advantages, and aspects of the various embodiments of the present disclosure would become more apparent in conjunction with the drawings and the following detailed description. Throughout the drawings, the same or similar reference numerals denote the same or similar elements. It should be understood that the drawings are schematic, and the elements and components are not necessarily drawn to scale.
FIG. 1 shows a flow chart of a method for manufacturing a film layer structure according to an embodiment of the present application.
FIG. 2 shows a schematic cross-sectional view of a film layer structure according to an embodiment of the present application.

### DETAILED DESCRIPTION OF EMBODIMENTS

Hereinafter specific embodiments of the present application are described in detail in conjunction with the accompanying drawings, in order to provide a clearer understanding of the above-mentioned objectives, features, and advantages of the present application.

The following description sets forth numerous specific details to facilitate a thorough understanding of the present application. Alternatively, the present application may be implemented in other forms not described herein. Those skilled in the art may make similar extensions without departing from the scope of the present application. Therefore, the present application is not limited to the specific embodiments disclosed below.

As described in the related art, a conventional inductively coupled plasma etching process is performed by alternating between two workflows: wafer etching followed by either chamber in-situ plasma cleaning or no-wafer cleaning.

The purpose of plasma cleaning is to remove defects or process byproducts deposited within the chamber after a previous plasma etching of a wafer. As the etching process proceeds for an extended period, the defects or deposited process byproducts accumulate continuously, making it difficult for the next wafer to be processed in a stable chamber environment. It is therefore essential to perform plasma cleaning after each wafer etching to remove deposits in the chamber.

However, the efficiency of plasma cleaning also depends on the surface condition of the film layer structure of the workpiece inside the chamber. Generally, the removal of the process byproducts via plasma cleaning becomes more effective on smoother and flatter film layer structure of the workpiece.

However, the surface of chamber liners currently in use is often insufficiently smooth and flat, with relatively high surface defects and roughness, which seriously impacts the stability and yield of the plasma etching process.

To address the above technical issues, embodiments of the present application provide a film layer structure and manufacturing method. The method comprises: providing a substrate; forming the first ceramic coating on the substrate via an atmospheric plasma spraying process or an evaporation process; forming the second ceramic coating on a side of the first ceramic coating away from the substrate via a suspension plasma spraying process; and forming the third ceramic coating on a side of the second ceramic coating away from the substrate via a chemical vapor deposition process or a physical vapor deposition process. The first ceramic coating, prepared in the present application via the atmospheric plasma spraying process or the evaporation process, exhibits excellent interfacial bonding strength, thereby facilitating bonding with the substrate. The second ceramic coating prepared by the suspension plasma spraying process can reduce the roughness and porosity of the film layer structure. The third ceramic coating prepared by the chemical vapor deposition process or the physical vapor deposition process can further reduce defects such as cracks in the film layer structure. Thus, a smooth, dense, crack-free film layer structure surface is obtained. Applying the smooth, dense, crack-free film structure to the chamber liner of the plasma apparatus facilitates enhancing the plasma cleaning function of the plasma cleaning on the process byproducts attached to the chamber liner during the plasma etching process, thereby improving the stability and yield of the plasma etching process.

To better understand the technical solutions and technical effects of the present application, specific embodiments will be described in detail below in conjunction with the accompanying drawings.

### Exemplary Method

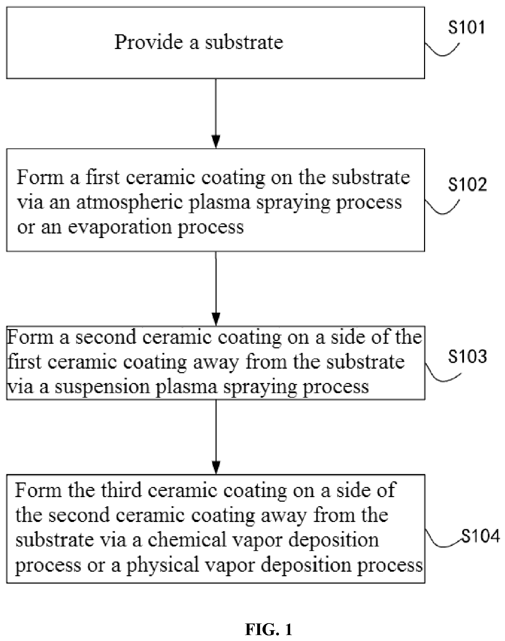

Reference is made to FIG. 1, which is a flow chart of a method for manufacturing a film layer structure according to an embodiment of the present application. The method comprises:
S101: Providing a substrate.

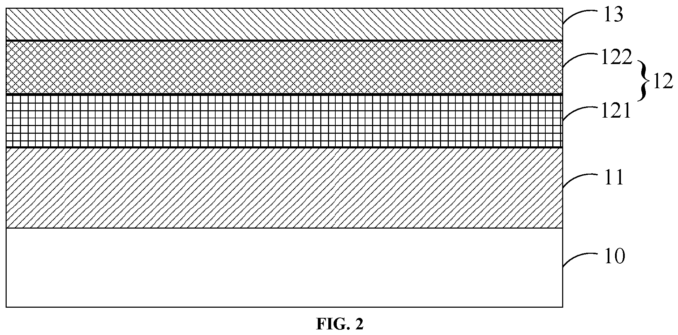

In an embodiment, reference is made to FIG. 2, which is a schematic diagram of a film layer structure according to an embodiment of the present application.

Specifically, a material of the substrate 10 may include aluminum. Optionally, the material of the substrate 10 may include aluminum alloy. In an embodiment, the aluminum alloy may include copper element, silicon element, iron element, manganese element, magnesium element, zinc element, chromium element, and/or titanium element. In an embodiment, aluminum or aluminum alloy is used as the substrate 10 due to its relatively light weight.

In an embodiment, the aluminum alloy may be 6061 aluminum plate alloy 6061T. That is, in the embodiment, primary alloy elements in the 6061 aluminum plate alloy are magnesium and silicon, and the 6061 aluminum plate alloy exhibits moderate strength, good corrosion resistance, weldability, and excellent oxidation resistance.

Optionally, in an embodiment, a hard anodizing treatment may be performed on a surface of the substrate 10. A hard, wear-resistant, and corrosion-resistant oxide film is formed on the surface of the substrate 10 via the hard anodizing treatment, which improves the surface hardness and durability of the substrate 10.

A multilayer ceramic coating is then formed on a side of the substrate 10. A roughness and porosity of the multilayer ceramic coating gradually decrease from a side closest to the substrate 10 to a side away from the substrate 10. Thus, the embodiment of the present application achieves a smooth and dense surface by gradually decreasing the roughness and porosity of the multilayer ceramic coating.

Optionally, the multilayer ceramic coating may comprise a first ceramic coating 11, a second ceramic coating 12, and a third ceramic coating 13. Forming the multilayer ceramic coating on a side of the substrate 10 may specifically comprise the following steps: S102-S104.

S102: Forming the first ceramic coating on the substrate via an atmospheric plasma spraying process or an evaporation process.

In an embodiment, the first ceramic coating 11 may be formed on the substrate 10 via the atmospheric plasma spraying process (APS) or the evaporation process.

Optionally, a material of the first ceramic coating 11 may include aluminium oxide, yttrium oxide, yttrium fluoride, yttrium oxyfluoride, or yttrium aluminum garnet. Optionally, a thickness of the first ceramic coating 11 may be greater than or equal to 50 µm and less than or equal to 500 µm. Optionally, the porosity of the first ceramic coating 11 may be greater than or equal to 3% and less than or equal to 8%. Optionally, the roughness of the first ceramic coating may be greater than or equal to 3 µm and less than or equal to 8 µm.

Specifically, the first ceramic coating 11, formed via the atmospheric plasma spraying process or the evaporation process in embodiments of the present application, exhibits a certain degree of porosity and structural defects. But it has good interfacial bonding strength, facilitating bonding with the substrate 10 or subsequently formed film layers. The first ceramic coating 11 formed has a fast film-forming rate and relatively low cost.

However, since the first ceramic coating 11 formed via the atmospheric plasma spraying or the evaporation process has high surface roughness and high porosity, the plasma cleaning cannot completely remove deposition products within coating pores. Long-term accumulation would affect the chamber process and particle stability.

In other words, due to limitations of the thin film deposition process, the first ceramic coating 11 formed has a rough surface with high porosity, failing to provide a crack-free, dense, and smooth coating surface. This affects the cleaning capability of the plasma cleaning during the plasma etching process.

Therefore, in an embodiment, the second ceramic coating 12 is further formed.

S103: Forming the second ceramic coating on a side of the first ceramic coating away from the substrate via a suspension plasma spraying process.

In an embodiment, the suspension plasma spraying process (SPS) may be used to form the second ceramic coating 12 on the side of the first ceramic coating 11 away from the substrate 10.

Specifically, in an embodiment, the second ceramic coating 12 formed via the suspension plasma spraying process may be a ceramic film resistant to plasma etching with reduced porosity and roughness.

Optionally, a material of the second ceramic coating 12 may include aluminium oxide, yttrium oxide, yttrium fluoride, yttrium oxyfluoride, or yttrium aluminum garnet. A thickness of the second ceramic coating 12 may be similar to or the same as that of the first ceramic coating 11, and the surface roughness and porosity of the second ceramic coating 12 may be lower than those of the first ceramic coating 11.

Optionally, the second ceramic coating 12 may comprise a first ceramic sub-layer 121 and a second ceramic sub-layer 122 to further reduce the roughness and porosity of the film layer structure.

Optionally, the thickness of the second ceramic coating 12 may be greater than or equal to 50 µm and less than or equal to 500 µm. The porosity of the second ceramic coating 12 may be less than or equal to 3%. The roughness of the second ceramic coating 12 may be greater than or equal to 1.0 µm and less than or equal to 4 µm.

The double-layer coating formed by the first ceramic coating 11 and the second ceramic coating 12 has a low surface roughness (Ra) and porosity, but defects such as cracks still exist on the surface of the second ceramic coating 12. Therefore, the liner surface, protected by the double-layer coating formed by the first ceramic coating 11 and the second ceramic coating 12, is at risk of cracks inducing the accumulation of process byproducts. This would affect the cleaning effect of the plasma cleaning process on the chamber.

Therefore, in an embodiment, a third ceramic coating 13 is further formed.

S104: Forming the third ceramic coating on a side of the second ceramic coating away from the substrate via a chemical vapor deposition process, a physical vapor deposition process, a plasma-enhanced chemical vapor deposition process, or a plasma-enhanced physical vapor deposition process.

Specifically, in an embodiment, the third ceramic coating 13 may be formed on a side of the second ceramic coating 12 away from the substrate 10 via the chemical vapor deposition process (CVD), the physical vapor deposition process (PVD), the plasma-enhanced chemical vapor deposition process, or the plasma-enhanced physical vapor deposition process.

Specifically, in an embodiment, the third ceramic coating 13 formed via the chemical vapor deposition process or the physical vapor deposition process may be a dense, plasma-etch-resistant ceramic film with a smooth, defect-free surface.

Optionally, a material of the third ceramic coating 13 may include aluminium oxide, yttrium oxide, yttrium fluoride, yttrium oxyfluoride, or yttrium aluminum garnet. Optionally, a thickness of the third ceramic coating 13 may be greater than or equal to 2 µm and less than or equal to 200 µm. Optionally, a porosity of the third ceramic coating 13 may be less than or equal to 0.1%. Optionally, a roughness of the third ceramic coating may be less than or equal to 1 µm.

In an embodiment, the first ceramic coating 11, the second ceramic coating 12, and the third ceramic coating 13 are made of a single type of material, which ensures uniformity and consistency of the materials in each ceramic coating, thereby preventing the occurrence of coating delamination.

In an embodiment, the third ceramic coating 13 has a relatively low thickness. This ensures a smooth, defect-free surface while preventing cracking, thereby enhancing the quality of the formed third ceramic coating 13.

The third ceramic coating 13 is subsequently deposited on the second ceramic coating 12. Ceramic coatings such as yttrium oxide, formed via the chemical vapor deposition process or physical vapor deposition process, are dense and free of defects such as crack. Depositing the ceramic coatings on the surface of the second ceramic coating 12 may further reduce the coating's surface roughness (e.g., <1 µm) while eliminating the porosity and cracks in the second ceramic coating 12. Therefore, a smooth, dense, crack-free surface can be achieved by depositing the first ceramic coating 11, the second ceramic coating 12 and the third ceramic coating 13 in sequence on a plasma-etched aluminum workpiece, such as a liner. The surface is conductive to enhancing the plasma cleaning function of the plasma cleaning on the chamber during the plasma etching process.

It should be noted that when the third ceramic coating 13 is deposited directly on the surface of the first ceramic coating 11, due to the third ceramic coating 13 is relatively thin, the surface roughness of the liner protected by the first ceramic coating 11/third ceramic coating 13 is relatively high (e.g., 5-7 µm), and there is no significant difference compared with the roughness of the first ceramic coating 11 (3-8 µm). This would affect the cleaning effect of the plasma cleaning process on the chamber during the plasma etching process.

Therefore, in an embodiment, the third ceramic coating 13 is further deposited on the second ceramic coating 12 to gradually improve the coating surface roughness, resulting in a smooth, dense, crack-free film layer structure for application in the chamber liner of the plasma apparatus. This enhances the cleaning function of the plasma cleaning process on process byproducts attached to the chamber liner.

The embodiments of the present application provide a film layer structure and manufacturing method. The method comprises: providing a substrate; forming the first ceramic coating on the substrate via an atmospheric plasma spraying process or an evaporation process; forming the second ceramic coating on a side of the first ceramic coating away from the substrate via a suspension plasma spraying process; and forming the third ceramic coating on a side of the second ceramic coating away from the substrate via a chemical vapor deposition process or a physical vapor deposition process. The first ceramic coating, prepared in the present application via the atmospheric plasma spraying process or the evaporation process, exhibits excellent interfacial bonding strength, thereby facilitating bonding with the substrate. The second ceramic coating prepared by the suspension plasma spraying process can reduce the roughness and porosity of the film layer structure. The third ceramic coating prepared by the chemical vapor deposition process or the physical vapor deposition process can further reduce defects such as cracks in the film layer structure. Thus, a smooth, dense, crack-free film layer structure surface is obtained. Applying the smooth, dense, crack-free film structure to the chamber liner of the plasma apparatus facilitates enhancing the plasma cleaning function of the plasma cleaning on the process byproducts attached to the chamber liner during the plasma etching process, thereby improving the stability and yield of the plasma etching process.

### Exemplary Structure

The present application provides a film layer structure, which is applied to a plasma apparatus comprising a plasma etching device and a plasma coating device and is manufactured by the method described above. The film layer structure comprises:
a substrate 10; and
a multilayer ceramic coating located on one side of the substrate 10;
wherein a roughness and porosity of the multilayer ceramic coating gradually decreasing from a side close to the substrate 10 to a side away from the substrate 10.

In an embodiment, the multilayer ceramic coating may comprise a first ceramic coating 11, a second ceramic coating 12, and a third ceramic coating 13. Reference is made to FIG.2, which is a schematic diagram of a film layer structure according to an embodiment of the present application, the film layer structure may be manufactured by the method described above. The film layer structure comprises:
a substrate 10;
a first ceramic coating 11 located on a side of the substrate 10;
a second ceramic coating 12 located on a side of the first ceramic coating 11 away from the substrate 10; and
a third ceramic coating 13 located on a side of the second ceramic coating 12 away from the substrate 10.

In an embodiment, the second ceramic coating 12 comprises a first ceramic sub-layer 121 and a second ceramic sub-layer 122.

An embodiment of the present application provides a film layer structure. The method for manufacturing the film layer structure comprises: providing a substrate; forming the first ceramic coating on the substrate via an atmospheric plasma spraying process or an evaporation process; forming the second ceramic coating on a side of the first ceramic coating away from the substrate via a suspension plasma spraying process; and forming the third ceramic coating on a side of the second ceramic coating away from the substrate via a chemical vapor deposition process or a physical vapor deposition process. The first ceramic coating, prepared in the present application via the atmospheric plasma spraying process or the evaporation process, exhibits excellent interfacial bonding strength, thereby facilitating bonding with the substrate. The second ceramic coating prepared by the suspension plasma spraying process can reduce the roughness and porosity of the film layer structure. The third ceramic coating prepared by the chemical vapor deposition process or the physical vapor deposition process can further reduce defects such as cracks in the film layer structure. Thus, a smooth, dense, crack-free film layer structure surface is obtained. Applying the smooth, dense, crack-free film structure to the chamber liner of the plasma apparatus facilitates enhancing the plasma cleaning function of the plasma cleaning on the process byproducts attached to the chamber liner during the plasma etching process, thereby improving the stability and yield of the plasma etching process.

The various embodiments in the specification are described in a progressive manner. For the same or similar parts among the various embodiments, reference can be made to each other. Each embodiment focuses on the differences from the other embodiments. In particular, structural embodiments are described briefly because they are fundamentally similar to method embodiments. For relevant details, references can be made to the description of the method embodiments.

The foregoing merely represents preferred embodiments of the present application. Although the present application has been disclosed above with reference to preferred embodiments, this is not intended to limit the present application. Anyone skilled in the art can utilize the methods and technical content disclosed above to make numerous possible variations and modifications to the present application, or to create equivalent embodiments with equivalent variations, without departing from the scope of the present application. Therefore, any simple modifications, equivalent changes and modifications made to the above embodiments based on the technical essence of the present application, without departing from the content of the technical solution of the present application, shall still fall within the scope of protection of the technical solution of the present application.

## Claims

1. A method for manufacturing a film layer structure, wherein the film layer structure is applied to a plasma apparatus, and the method comprises:
providing a substrate; and
forming a multilayer ceramic coating on a side of the substrate;
wherein a roughness and a porosity of the multilayer ceramic coating gradually decrease from a side close to the substrate to a side away from the substrate.

2. The method according to claim 1, wherein the multilayer ceramic coating comprises a first ceramic coating, a second ceramic coating, and a third ceramic coating, and forming the multilayer ceramic coating on a side of the substrate comprises:
forming the first ceramic coating on the substrate via an atmospheric plasma spraying process or an evaporation process;
forming the second ceramic coating on a side of the first ceramic coating away from the substrate via a suspension plasma spraying process;
forming the third ceramic coating on a side of the second ceramic coating away from the substrate via a chemical vapor deposition process, a physical vapor deposition process, a plasma-enhanced chemical vapor deposition process, or a plasma-enhanced physical vapor deposition process.

3. The method according to claim 1, wherein a material of the substrate comprises aluminum or aluminum alloy.

4. The method according to claim 2, wherein a material of the first ceramic coating comprises aluminium oxide, yttrium oxide, yttrium fluoride, yttrium oxyfluoride or yttrium aluminum garnet.

5. The method according to claim 2, wherein a material of the second ceramic coating comprises aluminium oxide yttrium oxide, yttrium fluoride, yttrium oxyfluoride or yttrium aluminum garnet.

6. The method according to claim 2, wherein a material of the third ceramic coating comprises aluminium oxide, yttrium oxide, yttrium fluoride, yttrium oxyfluoride or yttrium aluminum garnet.

7. The method according to claim 2, wherein the second ceramic coating comprises a first ceramic sub-layer and a second ceramic sub-layer.

8. The method according to claim 2, wherein a thickness of the first ceramic coating is greater than or equal to 50 µm and less than or equal to 500 µm.

9. The method according to claim 2, wherein a thickness of the second ceramic coating is greater than or equal to 50 µm and less than or equal to 500 µm.

10. The method according to claim 2, wherein a thickness of the third ceramic coating is greater than or equal to 2 µm and less than or equal to 200 µm.

11. The method according to claim 2, wherein the porosity of the first ceramic coating is greater than or equal to 3% and less than or equal to 8%.

12. The method according to claim 2, wherein the porosity of the second ceramic coating is less than or equal to 3%.

13. The method according to claim 2, wherein the porosity of the third ceramic coating is less than or equal to 0.1%.

14. The method according to claim 2, wherein the roughness of the first ceramic coating is greater than or equal to 3 µm and less than or equal to 8 µm.

15. The method according to claim 2, wherein the roughness of the second ceramic coating is greater than or equal to 1.0 µm and less than or equal to 4 µm.

16. The method according to claim 2, wherein the roughness of the third ceramic coating is less than or equal to 1 µm.

17. The method according to claim 3, wherein the aluminum alloy comprises copper element, silicon element, iron element, manganese element, magnesium element, zinc element, chromium element and/or titanium element.

18. The method according to claim 17, wherein the aluminum alloy is 6061 aluminum plate alloy.

19. A film layer structure, wherein the film layer structure is applied to a plasma apparatus comprising a plasma etching device and a plasma coating device and is manufactured by the method according to any one of claims 1 to 19, and the film layer structure comprises:
a substrate; and
a multilayer ceramic coating, located on a side of the substrate;
wherein a roughness and a porosity of the multilayer ceramic coating gradually decrease from a side close to the substrate to a side away from the substrate.

20. The film layer structure according to claim 19, wherein the multilayer ceramic coating comprises a first ceramic coating, a second ceramic coating, and a third ceramic coating;
materials of the first ceramic coating, the second ceramic coating, and the third ceramic coating comprise aluminium oxide, yttrium oxide, yttrium fluoride, yttrium oxyfluoride or yttrium aluminum garnet.
